# EUROPEAN PATENT APPLICATION

(11) **EP 4 764 782 A1**
(43) Date of publication of application: **24.06.2026**
(21) Application number: 25177879.1
(22) Date of filing: 21.05.2025
(51) Int. Cl.: G06F 1/20, G06F 1/324, G06F 1/329, G06F 9/50

(54) **METHOD AND APPARATUS FOR IMPLEMENTING TEMPERATURE CONTROL BY ADJUSTING HARDWARE PARAMETER OF PROCESSOR IN INTEGRATED CIRCUIT, STORAGE MEDIUM, AND ELECTRONIC DEVICE**

(30) Priority: 17.12.2024 CN 202411863808
(71) Applicant: XG TECH PTE. LTD., Singapore 179098 (SG)
(72) Inventor: WEI, Lei, 179098 Singapore (SG); REN, Weicong, 179098 Singapore (SG)
(74) Representative: Epping - Hermann - Fischer

(57) **Abstract**

Embodiments of this disclosure provide a method and an apparatus for implementing temperature control by adjusting a hardware parameter of a processor in an integrated circuit, a storage medium, and an electronic device. The method includes: obtaining a corresponding temperature value for each of at least two processors in the integrated circuit; and then determining, based on the corresponding temperature value of the at least two processors, at least one target processor that requires temperature control from the at least two processors; subsequently, determining, based on the operating system running on the at least one target processor, a corresponding target hardware parameter for the at least one target processor; and finally running, based on the corresponding target hardware parameter of the at least one target processor, the operating system on the at least one target processor.

## Description

### FIELD OF THE INVENTION

This disclosure relates to the technical field of integrated circuits, and in particular, to a method and an apparatus for implementing temperature control by adjusting a hardware parameter of a processor in an integrated circuit, a storage medium, and an electronic device.

### BACKGROUND OF THE INVENTION

Some integrated circuits include at least two processors, each of which may run a respective different operating system and generate heat during running the respective operating system. When the heat generated by the processor running a certain operating system increases, temperature of that processor rises. Moreover, the heat generated by the processor with rising temperature may be conducted to other processors in the integrated circuit. As a result, temperature of the other processors in the integrated circuit also rises accordingly. When the temperature of the processor in the integrated circuit rises, stability of the processor when running the operating system may decrease.

### SUMMARY OF THE INVENTION

Embodiments of this disclosure provide a method and an apparatus for implementing temperature control by adjusting a hardware parameter of a processor in an integrated circuit, a storage medium, and an electronic device, which can improve stability of each processor in the integrated circuit when running an operating system.

According to a first aspect of this disclosure, a method for implementing temperature control by adjusting a hardware parameter of a processor in an integrated circuit is provided, including: obtaining a corresponding temperature value for each of at least two processors in the integrated circuit, wherein the at least two processors respectively run at least one corresponding operating system; determining, based on the corresponding temperature value of each of the at least two processors, at least one target processor that requires temperature control from the at least two processors; determining, based on the operating systems running on the at least one target processor, a corresponding target hardware parameter for the at least one target processor; and running, based on the corresponding target hardware parameter of the at least one target processor, the operating system on the at least one target processor.

According to a second aspect of this disclosure, an apparatus for implementing temperature control by adjusting a hardware parameter of a processor in an integrated circuit is provided, including: an obtaining module, configured to obtain a corresponding temperature value for each of at least two processors in the integrated circuit, wherein the at least two processors respectively run at least one corresponding operating system; a first determining module, configured to determine, based on the corresponding temperature value of each of the at least two processors, at least one target processor that requires temperature control from the at least two processors; a second determining module, configured to determine, based on the operating systems running on the at least one target processor, a corresponding target hardware parameter for the at least one target processor; and a first running module, configured to run, based on the corresponding target hardware parameter of the at least one target processor, the operating system on the at least one target processor.

According to a third aspect of this disclosure, a computer storage medium is provided. The storage medium stores a computer program, and the computer program is used for implementing the method for implementing temperature control by adjusting a hardware parameter of a processor in an integrated circuit that is provided in the first aspect.

According to a fourth aspect of this disclosure, an electronic device is provided. The electronic device includes: a processor; and a memory configured to store processor-executable instructions, wherein the processor is configured to read the executable instructions from the memory, and execute the instructions to implement the method for implementing temperature control by adjusting a hardware parameter of a processor in an integrated circuit that is provided in the first aspect.

According to a fifth aspect of this disclosure, a computer program product is provided. When instructions in the computer program product are executed by a processor, the method for implementing temperature control by adjusting a hardware parameter of a processor in an integrated circuit that is provided in the first aspect is implemented.

According to the technical solutions provided in the embodiments of this disclosure, when the at least two processors in the integrated circuit respectively run at least one corresponding operating system, the corresponding temperature value of each of the at least two processors in the integrated circuit is obtained. In this way, heating statuses of various processors running various operating systems can be comprehensively obtained. Subsequently, at least one target processor that requires temperature control is determined from the at least two processors based on the corresponding temperature value of each of the at least two processors. In other words, the at least one target processor that requires temperature control corresponds to at least one operating system. Subsequently, the corresponding target hardware parameter is determined for the at least one target processor based on the operating systems running on the at least one target processor. Finally, the operating system on the at least one target processor is run based on the corresponding target hardware parameter of the at least one target processor. Because the corresponding target hardware parameter of each target processor is determined based on the operating system run on each target processor, running the operating system on each target processor based on the corresponding target hardware parameter of each target processor greatly reduces power consumption of each target processor during operation. In this case, an amount of heat generated by each target processor is reduced, thereby achieving an objective of adjusting the temperature of each target processor. In addition, performance of each target processor matches performance requirements of the operating system run on each target processor, thereby improving stability of each processor in the integrated circuit when running the operating system.

### BRIEF DESCRIPTION OF THE DRAWINGS

By describing embodiments of this disclosure more detailed with reference to accompanying drawings, the foregoing and other objectives, features, and advantages of this disclosure will become more apparent. The accompanying drawings are used to provide further understanding of the embodiments of this disclosure, constitute a part of the specification, are used to explain this disclosure together with the embodiments of this disclosure, and do not constitute limitation to this disclosure. In the accompanying drawings, same reference numerals generally represent same components or steps.
FIG. 1 is a schematic diagram of a structure of an integrated circuit according to an exemplary embodiment of this disclosure;
FIG. 2 is a schematic diagram of a structure of a temperature control system of an integrated circuit according to an exemplary embodiment of this disclosure;
FIG. 3 is a flowchart of a method for implementing temperature control by adjusting a hardware parameter of a processor in an integrated circuit according to an exemplary embodiment of this disclosure;
FIG. 4 is a flowchart of step 320 in a method for implementing temperature control by adjusting a hardware parameter of a processor in an integrated circuit according to an exemplary embodiment of this disclosure;
FIG. 5 is a flowchart of step 320 in a method for implementing temperature control by adjusting a hardware parameter of a processor in an integrated circuit according to another exemplary embodiment of this disclosure;
FIG. 6 is a flowchart of step 330 in a method for implementing temperature control by adjusting a hardware parameter of a processor in an integrated circuit according to an exemplary embodiment of this disclosure;
FIG. 7 is a flowchart of step 331 in a method for implementing temperature control by adjusting a hardware parameter of a processor in an integrated circuit according to an exemplary embodiment of this disclosure;
FIG. 8 is a flowchart of a method for implementing temperature control by adjusting a hardware parameter of a processor in an integrated circuit according to another exemplary embodiment of this disclosure;
FIG. 9 is a flowchart of a method for implementing temperature control by adjusting a hardware parameter of a processor in an integrated circuit according to still another exemplary embodiment of this disclosure;
FIG. 10 is a schematic diagram of a structure of an apparatus for implementing temperature control by adjusting a hardware parameter of a processor in an integrated circuit according to an exemplary embodiment of this disclosure;
FIG. 11 is a schematic diagram of a structure of an apparatus for implementing temperature control by adjusting a hardware parameter of a processor in an integrated circuit according to another exemplary embodiment of this disclosure;
FIG. 12 is a schematic diagram of a structure of an apparatus for implementing temperature control by adjusting a hardware parameter of a processor in an integrated circuit according to still another exemplary embodiment of this disclosure;
FIG. 13 is a schematic diagram of a structure of an apparatus for implementing temperature control by adjusting a hardware parameter of a processor in an integrated circuit according to yet another exemplary embodiment of this disclosure; and
FIG. 14 is a diagram of a structure of an electronic device according to an exemplary embodiment of this disclosure.

### DETAILED DESCRIPTION OF THE EMBODIMENTS

Exemplary embodiments of this disclosure are described below in detail with reference to accompanying drawings. Obviously, the embodiments described are merely some, rather than all of embodiments of this disclosure. It should be understood that this disclosure is not limited by the exemplary embodiments described herein.

It should be noted that unless otherwise specified, the scope of this disclosure is not limited by relative arrangement, numeric expressions, and numerical values of components and steps described in these embodiments.

### Application overview

Some integrated circuits may run at least two operating systems simultaneously. For example, in an intelligent vehicle, an onboard integrated circuit may run an intelligent driving operating system and a cockpit operating system simultaneously. The intelligent driving operating system is mainly responsible for autonomous driving and safety of the intelligent vehicle, including environmental perception, path planning, decision-making, and control. The cockpit operating system is mainly responsible for driving and riding experiences and human-machine interaction inside the intelligent vehicle, including information entertainment, instrument display, media playback, and environmental control.

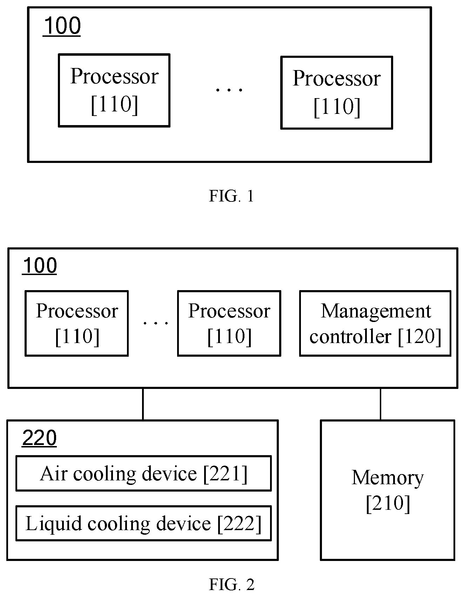

FIG. 1 is a schematic diagram of a structure of an integrated circuit according to an exemplary embodiment of this disclosure.

As shown in FIG. 1, an integrated circuit 100 may include at least two processors 110. The at least two processors 110 in the integrated circuit 100 respectively support running of at least two corresponding operating systems, and the running of each operating system may be supported by at least one processor 110 in the integrated circuit 100.

In some embodiments, the at least two processors 110 in the integrated circuit may include a general-purpose processor and/or a dedicated processor. The general-purpose processor may include a central processing unit (CPU), a graphics processing unit (GPU), or the like. The dedicated processor may include acceleration computing units designed for a deep learning task and an autonomous driving task, such as a neural network processing unit (NPU).

For example, the at least two processors 110 in the integrated circuit 100 may include at least one CPU, at least one GPU, and/or at least one NPU.

It may be understood that since the integrated circuit 100 is a semiconductor device, the at least two processors 110 in the integrated circuit 100 may generate heat during running the operating systems respectively. When the heat generated by the processor 110 running a certain operating system increases, temperature of that processor 110 rises. Moreover, the heat generated by the processor 110 with rising temperature may be conducted to other processors 110 in the integrated circuit 100. As a result, temperature of the other processors 110 in the integrated circuit 100 also rises accordingly. In other words, an increase in the temperature of any processor 110 in the integrated circuit 100 may lead to an increase in temperature of other processors 110 in the integrated circuit 100.

When the temperature of the processor 110 in the integrated circuit 100 rises, overheating protection such as underclocking and restart of the processor 110 may be triggered, so that stability of the at least two processors 110 in the integrated circuit 100 when running the operating systems respectively is reduced.

Regarding the foregoing technical problem, embodiments of this disclosure provide a method for implementing temperature control by adjusting a hardware parameter of a processor in an integrated circuit. According to this method, the stability of the at least two processors in the integrated circuit when running the operating systems respectively can be improved.

### Exemplary system

FIG. 2 is a schematic diagram of a structure of a temperature control system of an integrated circuit according to an exemplary embodiment of this disclosure.

As shown in FIG. 2, in an embodiment, the temperature control system of the integrated circuit includes:
an integrated circuit 100, a memory 210, and a temperature control device 220.

The integrated circuit 100 includes at least two processors 110, which may respectively run at least one corresponding operating system. For example, the at least two processors 110 in the integrated circuit 100 may respectively run an intelligent driving operating system and a cockpit operating system.

The memory 210 may include an internal memory and/or an external memory. The internal memory may be configured to store computer program instructions to be executed by the processor 110 and instructions execution results. The external memory may be configured to store a system file of the operating system, a program file of an application program, a document, a media file, and the like. For example, the internal memory may include a random access memory (RAM), such as a dynamic random access memory (dynamic RAM, DRAM) or a static random access memory (static RAM, SRAM). The external memory may include a read-only memory (ROM), an erasable programmable read-only memory (EPROM), a flash memory, and the like.

In an embodiment, when the computer program instructions stored in the memory 210 (such as the internal memory and/or the external memory) are executed by one or more processors 110 in the integrated circuit 100, the integrated circuit 100 is enabled to implement the method for implementing temperature control by adjusting a hardware parameter of a processor in an integrated circuit that is provided in exemplary embodiments of this disclosure.

The temperature control device 220 may include at least one device that can transfer and dissipate heat in the integrated circuit 100. For example, the temperature control device 220 may include at least one air cooling device 221 and/or at least one liquid cooling device 222. The air cooling device 221 may include, for example, a radiator fan. The liquid cooling device 222 may include, for example, a liquid-cooling heat dissipation module. The temperature control device 220 may be either a temperature control device corresponding to the integrated circuit 100 or a temperature control device corresponding to an electronic device containing the integrated circuit 100. For example, the cooling fan may be a cooling fan corresponding to the integrated circuit 100, or may be a cooling fan corresponding to a vehicle-mounted computing device of an intelligent vehicle. This is not limited in the embodiments of this disclosure.

In an implementation, the integrated circuit 100 may also include a management controller 120. The management controller 120 may be a circuit unit in the integrated circuit 100, and may adjust a hardware parameter of each processor 110 in the integrated circuit 100. The hardware parameter of the processor 110 may include clock frequency and/or a working voltage of the processor 110. For example, the management controller 120 may be a power management unit (PMU).

In an implementation, at least one processor 110 in the integrated circuit 100 may generate hardware parameter adjustment instructions. The management controller 120 may adjust the hardware parameter of the at least one processor 110 in the integrated circuit 100 based on the hardware parameter adjustment instructions, such as adjust the clock frequency and/or the working voltage of the at least one processor 110.

### Exemplary method

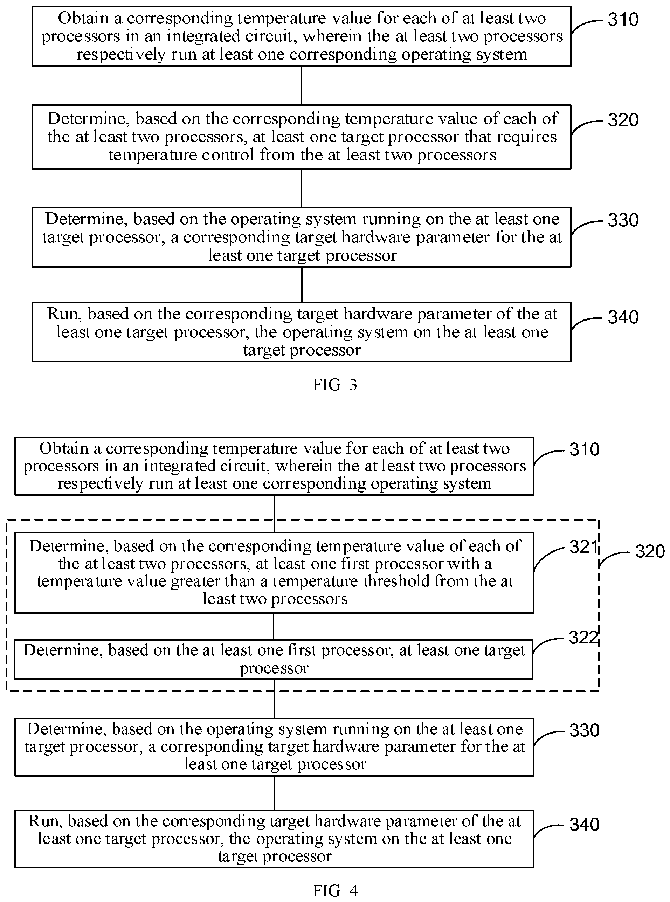

FIG. 3 is a flowchart of a method for implementing temperature control by adjusting a hardware parameter of a processor in an integrated circuit according to an exemplary embodiment of this disclosure.

As shown in FIG. 3, in an embodiment, the method may include the following steps.

Step 310. Obtain a corresponding temperature value for each of at least two processors in the integrated circuit, wherein the at least two processors respectively run at least one corresponding operating system.

The at least two processors in the integrated circuit may be any type of processors, for example, may include but are not limited to a CPU, a GPU, and an NPU.

In an implementation, a corresponding temperature value of each processor may be collected by using a temperature sensor disposed inside each processor or by using a temperature sensor disposed nearby each processor. For example, the temperature value of the CPU may be collected by using the temperature sensor disposed inside or nearby the CPU, and the temperature value of the GPU may be collected by using the temperature sensor inside or nearby the GPU.

In an implementation, a temperature value of a substrate of the integrated circuit may also be collected by using a temperature sensor. For example, at least one temperature sensor may be disposed on the substrate of the integrated circuit, so as to collect a temperature value of at least one position on the substrate.

In an implementation, a temperature value of another processor in the integrated circuit may also be collected by using a temperature sensor. For example, the integrated circuit may also include an image signal processor (ISP), a digital signal processor (DSP), a microcontroller unit (MCU), and/or a memory controller. Correspondingly, temperature values of the ISP, the DSP, the MCU, and/or the memory controller may also be collected by using temperature sensors. This is not limited in this embodiment of this disclosure.

In an implementation, temperature values corresponding to each processor may be periodically collected by using the temperature sensor. In this way, temperature changes of each processor may be determined based on a plurality of temperature values collected in a period of time. For example, the temperature changes may include increased temperature, constant temperature, and decreased temperature.

It may be understood that the processors in the integrated circuit may be distributed in different on-chip regions. Therefore, based on the distribution of the processors in the integrated circuit and distribution of the temperature sensors, the integrated circuit may include a plurality of on-chip temperature regions. For example, an on-chip region corresponding to at least one processor running a same operating system in the integrated circuit corresponds to one on-chip temperature region. For another example, an on-chip region corresponding to each processor in the integrated circuit corresponds to one on-chip temperature region.

In addition, the on-chip temperature region may also correspond to a substrate region of the integrated circuit, an on-chip region corresponding to the memory controller, an on-chip region corresponding to the SRAM, and an on-chip region corresponding to the DRAM. This is not limited in this embodiment of this disclosure.

In an implementation, a temperature value corresponding to the on-chip temperature region of the integrated circuit may be obtained, which may be used as a temperature value corresponding to the processor within the on-chip temperature region. For example, the temperature value corresponding to the on-chip temperature region may be obtained by using the temperature sensor distributed in the on-chip temperature region. The temperature sensor in the on-chip temperature region may include a temperature sensor disposed in the processor in the on-chip temperature region, and may also include a temperature sensor disposed on a substrate in the on-chip temperature region.

Step 320. Determine, based on the corresponding temperature value of each of the at least two processors, at least one target processor that requires temperature control from the at least two processors.

In an implementation, the at least one target processor that requires temperature control may be determined from the at least two processors based on a relationship between the corresponding temperature value and a corresponding temperature threshold of each of the at least two processors. Temperature thresholds corresponding to different processors in the at least two processors may be same or different. For example, the temperature threshold corresponding to the processor may be 50°C, 55°C, 60°C, 65°C, 75°C, or other values. This is not limited in this embodiment of this disclosure.

For example, for any processor in the at least two processors, such as a processor A, if a temperature value corresponding to the processor A is higher than a temperature threshold corresponding to the processor A, it is determined that the processor A is the target processor that requires temperature control.

For example, for the at least two processors in the integrated circuit, such as a processor A and a processor B, if a temperature value corresponding to the processor A is higher than a temperature threshold corresponding to the processor A, it is determined that the processor A and the processor B are target processors that require temperature control. To be specific, considering that the temperature value of the processor B increases because heat generated by the processor A may be conducted to the processor B, when the temperature value of the processor A is higher than the temperature threshold corresponding to the processor A, it may be determined that not only the processor A is the target processor that requires temperature control, but also the processor B is the target processor that requires temperature control.

In an implementation, a corresponding temperature-value variation trend may be determined for each of the at least two processors based on the corresponding temperature value of each of the at least two processors. The at least one target processor that requires temperature control may be determined from the at least two processors based on the corresponding temperature-value variation trend of each of the at least two processors. The temperature-value variation trend may include an increased temperature value, decreased temperature value, and/or a constant temperature value, etc.

For example, for any processor in the at least two processors, such as the processor A, if the temperature value of the processor A increases, it is determined that the processor A is the target processor that requires temperature control.

For example, for the at least two processors in the integrated circuit, such as the processor A and the processor B, if the temperature value corresponding to the processor A increases, it is determined that both the processor A and the processor B are processors that require temperature control. To be specific, considering that the heat generated by the processor A may be conducted to the processor B, if the temperature value of the processor A increases, the temperature value of the processor B may also increase accordingly. Therefore, when the temperature value of the processor A increases, it may be determined that not only the processor A is a processor that requires temperature control, but also the processor B is a processor that requires temperature control.

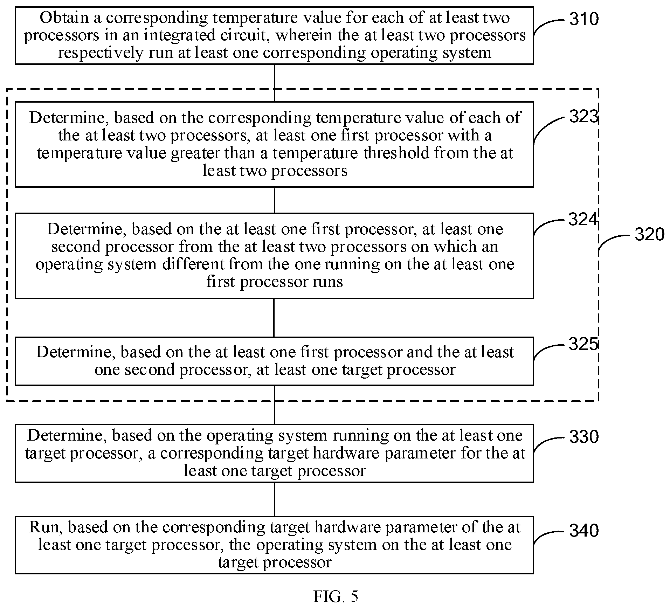

A specific manner of determining the processor that requires temperature control from the at least two processors based on the corresponding temperature value of each of the at least two processors may be further described in the following embodiments in combination with FIG. 4 and FIG. 5.

Step 330. Determine, based on the operating systems respectively running on the at least one target processor, a corresponding target hardware parameter for the at least one target processor.

In this embodiment of this disclosure, a hardware parameter of the processor may include a parameter of the processor when running the operating system, for example, may include clock frequency and/or a working voltage of the processor. It may be understood that the hardware parameter of the processor is a variable parameter.

Generally, the hardware parameter of the processor is related to an amount of heat generated by the processor when running the operating system. A higher hardware parameter of the processor (for example, higher clock frequency and/or a higher working voltage of the processor) indicates higher power consumption of the processor when running the operating system. Correspondingly, a larger amount of heat is generated by the processor. On the contrary, a lower hardware parameter of the processor (for example, lower clock frequency and/or a lower working voltage of the processor) indicates lower power consumption of the processor when running the operating system. Correspondingly, a smaller amount of heat is generated by the processor.

Therefore, to perform temperature control on the target processor, for each target processor, the target hardware parameter corresponding to the target processor is lower than a current hardware parameter corresponding to the target processor. For example, target clock frequency corresponding to the target processor is lower than current clock frequency corresponding to the target processor, and/or a target working voltage corresponding to the target processor is lower than a current working voltage corresponding to the target processor. In this way, when the target processor runs the operating system based on the target hardware parameter, a smaller amount of heat is generated by the processor.

Generally, the hardware parameter of the processor is related to performance of the processor. The performance of the processor may include computing power (CP for short) of the processor. For example, the computing power of the processor may be measured by using a quantity of instructions and/or operations that the processor can execute per unit of time. A higher hardware parameter of the processor (for example, higher clock frequency and/or a higher working voltage of the processor) indicates higher performance of the processor. Correspondingly, a lower hardware parameter of the processor (for example, lower clock frequency and/or a lower working voltage of the processor) indicates lower performance of the processor.

It may be understood that during a period of running the operating system by the processor, the operating system needs to utilize the computing power of the processor to perform corresponding tasks. For example, tasks performed by an intelligent driving operating system include an intelligent driving task and an automatic parking task, and tasks performed by a cockpit operating system include a media playback task and a navigation task. However, because different operating systems perform different tasks, different operating systems have different performance requirements for the processors. Therefore, in this embodiment of this disclosure, the corresponding target hardware parameter is determined for the at least one target processor based on the operating system running on the at least one target processor, so that when the target processor runs the operating system based on the corresponding target hardware parameter, the performance of the target processor matches the performance requirements of the operating system run on the target processor.

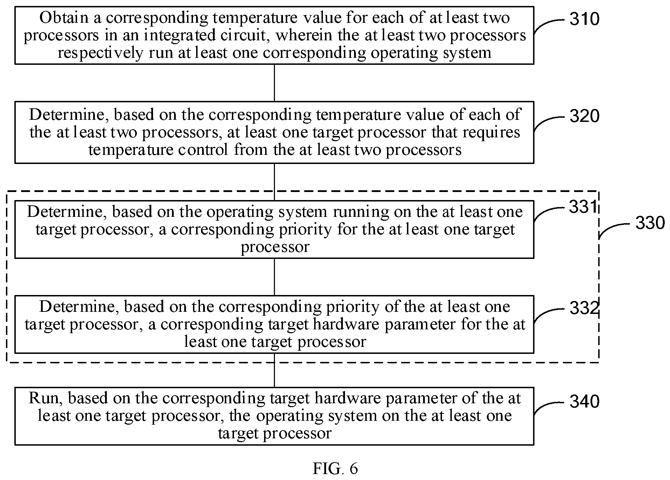

A specific manner of running the operating system on the at least one target processor based on the corresponding target hardware parameter of the at least one target processor may be further described in the following embodiments in combination with FIG. 6.

Step 340. Run, based on the corresponding target hardware parameter of the at least one target processor, the operating system on the at least one target processor.

In an implementation, running the operating system on the at least one target processor based on the corresponding target hardware parameter of the at least one target processor includes: the at least one target processor runs the corresponding operating system through the corresponding target hardware parameter.

For example, the at least one target processor may run the corresponding operating system at corresponding target clock frequency. For example, if target clock frequency corresponding to a target processor A is 2.0 GHz, the target processor A runs the corresponding operating system at clock frequency of 2.0 GHz.

For example, the at least one target processor may run the corresponding operating system at a corresponding target working voltage. For example, if a target working voltage corresponding to a target processor A is 1.2V, the target processor A runs the corresponding operating system at a working voltage of 1.2V.

For example, the at least one target processor may run the corresponding operating system at a corresponding working voltage and corresponding target clock frequency. For example, if target clock frequency corresponding to a target processor A is 1.0 GHz and a target working voltage corresponding thereto is 1.2V, the target processor A runs the corresponding operating system at clock frequency of 1.0 GHz and a working voltage of 1.2V.

In another implementation, running the operating system on the at least one target processor based on the corresponding target hardware parameter of the at least one target processor includes: the at least one target processor determines a corresponding target hardware parameter range based on the corresponding target hardware parameter and a preset deviation value, and runs the corresponding operating system through any hardware parameter within the corresponding target hardware parameter range. In other words, the hardware parameter of each target processor when running the corresponding operating system may fluctuate within the target hardware parameter range.

In an implementation, taking any target processor A as an example, the target processor A may execute program instructions of the operating system to generate a hardware parameter adjustment instruction corresponding to the target processor A. The hardware parameter adjustment instruction is used to indicate the target hardware parameter corresponding to the target processor A. For example, the hardware parameter adjustment instruction may include the target hardware parameter corresponding to the target processor A. A management controller may adjust a hardware parameter of the target processor A based on the hardware parameter adjustment instruction corresponding to the target processor A, such as adjust the clock frequency and/or the working voltage of the target processor A, so that the target processor A runs the operating system thereon based on the target hardware parameter.

For example, the hardware parameter adjustment instruction indicates that the target clock frequency corresponding to the target processor A is 1.0 GHz. The management controller may adjust the clock frequency of the target processor A to 1.0 GHz based on the hardware parameter adjustment instruction, so that the target processor A runs the operating system thereon at the clock frequency of 1.0 GHz. Alternatively, the management controller may adjust the clock frequency of the target processor A to any frequency within a preset fluctuation range taking 1.0 GHz as a center based on the hardware parameter adjustment instruction, so that the target processor A runs the operating system thereon at any frequency within the preset fluctuation range taking 1.0 GHz as the center.

It may be learned from the foregoing technical solutions that, according to the method provided in this embodiment of this disclosure, when the at least two processors in the integrated circuit respectively run at least one corresponding operating system, the corresponding temperature value of each of the at least two processors in the integrated circuit is obtained. In this way, heating statuses of various processors running various operating systems can be comprehensively obtained. Subsequently, at least one target processor that requires temperature control is determined from the at least two processors based on the corresponding temperature value of each of the at least two processors. In other words, the at least one target processor that requires temperature control corresponds to at least one operating system. Subsequently, the corresponding target hardware parameter is determined for the at least one target processor based on the operating system running on the at least one target processor. Finally, the operating system on the at least one target processor is run based on the corresponding target hardware parameter of the at least one target processor. Because the corresponding target hardware parameter of each target processor is determined based on the operating system run on each target processor, running the operating system on each target processor based on the corresponding target hardware parameter of each target processor greatly reduces power consumption of each target processor during operation. In this case, an amount of heat generated by each target processor is reduced, thereby achieving an objective of reducing the temperature of each target processor. In addition, the performance of each target processor matches the performance requirements of the operating system run on each target processor, thereby improving stability of each processor in the integrated circuit when running the operating system.

FIG. 4 is a flowchart of step 320 in a method for implementing temperature control by adjusting a hardware parameter of a processor in an integrated circuit according to an exemplary embodiment of this disclosure.

As shown in FIG. 4, on the basis of the embodiment shown in FIG. 3, step 320 includes the following steps.

Step 321. Determine, based on the corresponding temperature value of each of the at least two processors, at least one first processor with a temperature value greater than a temperature threshold from the at least two processors.

Generally, the stability of the processor when running the operating system is related to the temperature value of the processor. When the temperature value of the processor increases, the processor cannot run the operating system stably. When the temperature value of the processor is equal to or greater than an overheat protection temperature value of the processor, the processor may trigger overheat protection, causing the processor to restart. That the processor cannot run the operating system stably includes but is not limited to at least one of the following situations: The processor underclocks automatically (that is, automatically reduces the clock frequency), which results in performance degradation and affects an execution speed of a task in the operating system; the processor has calculation errors and/or memory access exceptions; and the operating system running on the processor crashes, automatically restarts, and/or shuts down.

In an implementation, the temperature threshold corresponding to the processor may be determined based on the temperature value or a temperature value range for which the processor can stably run the operating system. To be specific, when the temperature value of the processor is greater than the corresponding temperature threshold, the processor cannot run the operating system stably. When the temperature value of the processor is lower than or equal to the corresponding temperature threshold, the processor can run the operating system stably.

In an implementation, the temperature threshold corresponding to the processor is lower than the overheat protection temperature value of the processor. To be specific, when the temperature value of the processor is greater than the corresponding temperature threshold and is lower than the overheat protection temperature value, the processor cannot run the operating system stably but does not trigger the overheat protection. The processor triggers the overheat protection when the temperature value of the processor is equal to or greater than the overheat protection temperature value.

Temperature thresholds corresponding to the various processors in the integrated circuit may be same or different.

For example, for any processor in the integrated circuit, the temperature threshold corresponding to that processor may be determined based on a difference between the overheat protection temperature value of that processor and a preset temperature value offset. For example, if the temperature value offset is 10 °C and the overheat protection temperature value of the processor A is 80°C, the temperature threshold corresponding to the processor A may be 70°C, that is, 80°C-10°C. In other words, if the temperature value of the processor A is greater than 70°C, it may be determined that the processor A is the first processor.

For example, a same temperature threshold corresponding to the at least two processors may be determined based on overheat protection temperature values of the at least two processors in the integrated circuit. The temperature threshold is lower than the corresponding overheat protection temperature value of each of the at least two processors. For example, if the overheat protection temperature value of the processor A is 80°C and the overheat protection temperature value of the processor B is 85°C, the temperature threshold corresponding to the processor A and the processor B may be 65°C, 70°C, or 75°C.

Step 322. Determine, based on the at least one first processor, the at least one target processor.

In an implementation, the target processor may include the first processor. To be specific, the target processor may include a processor in the integrated circuit that has a temperature value greater than the temperature threshold.

For example, if the first processor includes the processor A and the processor B, the processor A and the processor B are target processors.

In an implementation, the target processor may include the first processor, and may also include a processor that runs a same operating system as the first processor.

For example, if the first processor includes the processor A and the processor A runs a same operating system as a processor C, both the processor A and the processor C are target processors.

For example, if the first processor includes the processor A and the processor B, the processor A runs a same operating system as a processor C, and the processor B runs a same operating system as a processor D, the processor A, the processor B, the processor C, and the processor D are all target processors.

In this embodiment of this disclosure, when the temperature value of the processor is greater than the temperature threshold, the processor may cannot run the operating system stably. Therefore, determining the processor with the temperature value greater than the temperature threshold as the first processor may filter out the processor in the integrated circuit that cannot run the operating system stably. On this basis, determining the at least one target processor based on the at least one first processor may accurately determine the processor in the integrated circuit that cannot run the operating system stably as the target processor that requires temperature control. In this way, subsequent temperature control for the target processor may improve stability of the target processor when running the operating system.

FIG. 5 is a flowchart of step 320 in a method for implementing temperature control by adjusting a hardware parameter of a processor in an integrated circuit according to another exemplary embodiment of this disclosure.

As shown in FIG. 5, on the basis of the embodiment shown in FIG. 3, step 320 includes the following steps.

Step 323. Determine, based on the corresponding temperature value of each of the at least two processors, at least one first processor with a temperature value greater than a temperature threshold from the at least two processors.

For specific implementation of step 323, reference may be made to step 321, and details are not described herein.

Step 324. Determine, based on the at least one first processor, at least one second processor from the at least two processors on which an operating system different from the one running on the at least one first processor runs.

The at least one second processor may include all or some of processors in the integrated circuit that run different operating systems from the at least one first processor. It may be understood that when there are a plurality of first processors, the plurality of first processors may run a same operating system or a plurality of different operating systems. Therefore, when the plurality of first processors run a same operating system, for example, run an operating system a, the at least one second processor may include all or some of processors, in the integrated circuit, except the processors running the operating system a. In addition, when the plurality of first processors run a plurality of different operating systems, for example, run the operating system a and an operating system b, the at least one second processor may include all or some of processors, in the integrated circuit, except the processors running the operating system a and the operating system b.

For example, the at least two processors in the integrated circuit include the processor A, the processor B, and the processor C, wherein the processor A runs the operating system a, the processor B runs the operating system b, and the processor C runs an operating system c. In this case, if the temperature value of the processor A is greater than the temperature threshold, the processor A is a first processor, and the processor B and the processor C are second processors. Similarly, if the temperature values of the processor A and the processor B are greater than the temperature threshold, the processor A and the processor B are first processors, and the processor C is a second processor.

Step 325. Determine, based on the at least one first processor and the at least one second processor, the at least one target processor.

In an implementation, the at least one target processor may include all processors in the at least one first processor and all processors in the at least one second processor.

In an implementation, the at least one target processor may include all processors in the at least one first processor and some processors in the at least one second processor.

For example, the at least one target processor includes all processors in the at least one first processor, and also includes at least one processor adjacent to any first processor in the at least one second processor. For example, if the first processor includes the processor A and the processor B and the second processor includes the processor C, a processor D, and a processor E, wherein the processor A is adjacent to the processor C, the processor B is adjacent to the processor D, and the processor E is not adjacent to either the processor A or the processor B, the target processor may include the processor A, the processor B, the processor C, and the processor D.

In this embodiment of this disclosure, considering that heat generated by various processors in the integrated circuit may be conducted to each other, when the temperature of the processor running one of the operating systems rises, the heat may be conducted to the processors running the other operating systems. As a result, the temperature of the processors running the other operating systems also rises accordingly. Therefore, in addition to the first processor, the target processor also includes the second processor that runs a different operating system from the first processor. In this way, when performing temperature control on the target processor later, the temperature of the processors running different operating systems may be adjusted simultaneously, thereby improving stability of the processors in the integrated circuit when running different operating systems.

FIG. 6 is a flowchart of step 330 in a method for implementing temperature control by adjusting a hardware parameter of a processor in an integrated circuit according to an exemplary embodiment of this disclosure.

As shown in FIG. 6, on the basis of the embodiment shown in any one of FIG. 3 to FIG. 5, step 330 may include the following steps.

Step 331. Determine, based on the operating systems respectively running on the at least one target processor, a corresponding priority for the at least one target processor.

The priority corresponding to the target processor is related to the operating system run on the target processor, and priorities corresponding to the target processors running different operating systems are different.

For example, when the processor A runs the intelligent driving operating system and the processor B runs the cockpit operating system, the intelligent driving operating system needs to utilize computing power of the processor A to perform the intelligent driving task. In this case, it is required to preferentially make sure that the performance of the processor A meets performance requirements of the intelligent driving operating system. Therefore, the priority corresponding to the processor A is relatively higher, while the priority corresponding to the processor B is relatively lower. In other words, the priority of the processor A is higher than that of the processor B.

For example, the priority corresponding to each target processor may include a high priority, a medium priority, or a low priority. For example, the processor A runs the intelligent driving operating system and corresponds to the high priority, while the processor B runs the cockpit operating system and corresponds to the low priority.

For example, the priority corresponding to each target processor may also be represented by using a priority value. For example, the priority value may be any integer value between 1 and 9, wherein a larger priority value indicates a higher priority. For example, the processor A runs the intelligent driving operating system and corresponds to a priority value of 9, while the processor B runs the cockpit operating system and corresponds to a priority value of 3. In other words, the priority of the processor A is higher than that of the processor B.

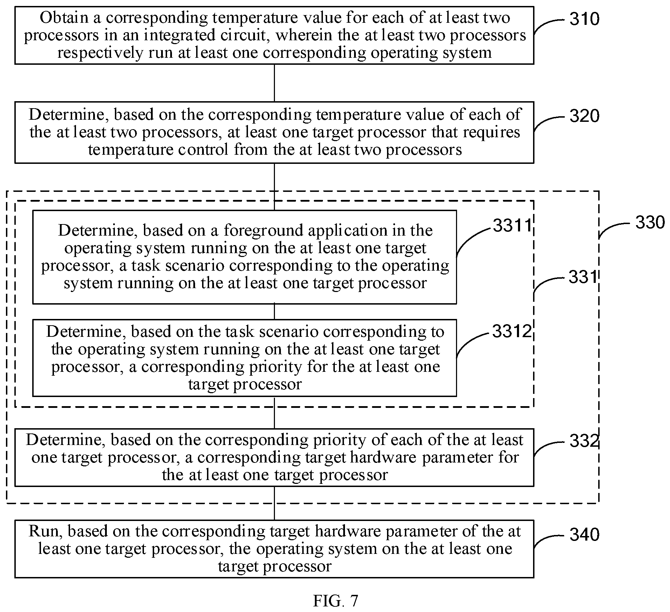

A specific manner of determining the corresponding priority for the at least one target processor based on the operating system running on the at least one target processor may be further described in the following embodiments in combination with FIG. 7.

Step 332. Determine, based on the corresponding priority of each of the at least one target processor, the corresponding target hardware parameter for the at least one target processor.

The target hardware parameter of the target processor is related to the priority thereof. A higher priority of the target processor indicates a higher target hardware parameter of the target processor. When the target processor runs the operating system with the target hardware parameter, higher performance indicates a larger amount of heat. On the contrary, a lower priority of the target processor indicates a lower target hardware parameter of the target processor. When the target processor runs the operating system with the target hardware parameter, lower performance indicates a smaller amount of heat.

In an implementation, the priority and the target hardware parameter of each processor has a corresponding relationship. The corresponding relationship between the priority and the target hardware parameter of each processor may be pre-configured, or may be dynamically configured during the process in which each processor runs the operating system. This is not limited in this embodiment of this disclosure. In this way, for any target processor, the target hardware parameter of that target processor may be determined based on the corresponding relationship between the priority and the target hardware parameter of that target processor.

For example, the target processor includes the processor A, which is a CPU. When the hardware parameter corresponding to the processor A is not adjusted, the processor A runs the operating system with a default hardware parameter. For example, the processor A runs the operating system with default clock frequency of 2.0 GHz. In this case, when the processor A corresponds to the high priority, the corresponding target hardware parameter may be 1.5 GHz. When the processor A corresponds to the medium priority, the corresponding target hardware parameter may be 1.2 GHz. When the processor A corresponds to the low priority, the corresponding target hardware parameter may be 0.9 GHz. In other words, the target hardware parameter of the processor A is lower than the default hardware parameter.

In an implementation, the priority and a hardware parameter adjustment value of the processor has a corresponding relationship. The hardware parameter adjustment value may include a clock frequency adjustment value and/or a working voltage adjustment value. Different priorities correspond to different hardware parameter adjustment values. A higher priority of the processor indicates a smaller corresponding hardware parameter adjustment value, and a lower priority of the processor indicates a larger corresponding hardware parameter adjustment value. In this way, for any target processor, the target hardware parameter of that target processor may be determined based on a difference between the current hardware parameter and the hardware parameter adjustment value of that target processor.

For example, the target processor includes the processor A, which is a CPU; and current clock frequency of the processor A is 2.2 GHz. A clock frequency adjustment value corresponding to the high priority is 0.4 GHz, a clock frequency adjustment value corresponding to the medium priority is 0.8 GHz, and a clock frequency adjustment value corresponding to the low priority is 1.2 GHz. When the target processor corresponds to the high priority, the target clock frequency may be 1.8 GHz (2.2 GHz-0.4 GHz). When the target processor corresponds to the medium priority, the target clock frequency may be 1.4 GHz (2.2 GHz-0.8 GHz). When the target processor corresponds to the low priority, the target clock frequency may be 1.0 GHz (2.2 GHz-1.2 GHz).

In this embodiment of this disclosure, considering that different operating systems have different performance requirements for the target processor, the corresponding priority is determined for each target processor based on the operating system run on the target processor. Subsequently, the target hardware parameter corresponding to the target processor is determined based on the priority corresponding to the target processor. In this way, when the target processor runs the operating system based on the target hardware parameter, the performance of the target processor matches the performance requirements of the operating system running on the target processor, so that the stability of the target processor when running the operating system can be improved.

FIG. 7 is a flowchart of step 331 in a method for implementing temperature control by adjusting a hardware parameter of a processor in an integrated circuit according to an exemplary embodiment of this disclosure.

As shown in FIG. 7, on the basis of the embodiment shown in FIG. 6, step 331 may further include the following steps.

Step 3311. Determine, based on a foreground application in the operating system running on the at least one target processor, a task scenario corresponding to the operating systems respectively running on the at least one target processor.

Generally, applications currently running in the operating system may include an application currently running in foreground and an application currently running in background. The application running in the foreground may be referred to as a foreground application. "Running in the foreground" herein indicates that the application is currently running and displays content on a display screen. In an example, the foreground application may specifically include a foreground focus application and a foreground non-focus application. The foreground focus application includes an application that displays content on the display screen and is being operated by a user, and the foreground non-focus application includes an application that is displayed on the display screen but is not operated by the user. Correspondingly, the application running in the background may be referred to as a background application. "Running in the background" herein indicates that the application is currently running but does not display content on the display screen.

When an application is running in the foreground, it usually means that this application is currently used by the user. For example, when the user is watching a video, a video application may run in the foreground to play video content. When an application is running in the background, it usually means that this application is currently not being used by the user. For example, when the user is not watching a video, the video application may be switched to run in the background. In view of the above, the task scenario corresponding to the operating system may be determined based on the foreground application in the operating system.

In an implementation, each operating system may correspond to a plurality of task scenarios. Taking that the at least two operating systems run on each of the at least two processors in the integrated circuit include the intelligent driving operating system and the cockpit operating system as an example, the task scenarios may include:
a driving scenario: a vehicle is in a driving status;
a parking scenario: the vehicle is in a parking status;
an intelligent driving scenario: the vehicle is driving and an intelligent driving function is enabled;
a manned driving scenario: the vehicle is driving and the intelligent driving function is disabled;
a standby scenario: the operating system is in a standby status;
an entertainment scenario: the operating system is playing music, playing a video, or running a game application, where the entertainment scenario may be further subdivided into a music scenario, a video scenario, a game scenario, and the like;
a touch scenario: the user is performing touch operations on a user interface of the operating system;
a voice scenario: the operating system is performing voice recognition; and
a navigation scenario: the operating system is running a map application.

It should be noted herein that quantities and types of application scenarios corresponding to different operating systems may be same or different. For example, both the intelligent driving operating system and the cockpit operating system may include the driving scenario, the parking scenario, the intelligent driving scenario, and the manned driving scenario. However, the cockpit operating system also includes the entertainment scenario, while the intelligent driving operating system may not include the entertainment scenario. The quantity and the types of the application scenarios corresponding to each operating system are not specifically limited in this embodiment of this disclosure.

In an implementation, for any target processor, the task scenario corresponding to the operating system run on the target processor may be determined based on application information of the foreground application in the operating system run on the target processor.

For example, the application information of the foreground application may include an application name, a package name, and/or a process name of the foreground application. For example, an application name of an application app1 may be "app1", a package name may be "com.xxx.app1", and a process name may be "app1.exe". In this way, the scenario corresponding to the operating system may be determined based on the application information of the foreground application.

For example, if it is determined based on the application information of the foreground application that the foreground application in the intelligent driving operating system includes an intelligent driving application, it may be determined that the task scenario corresponding to the intelligent driving operating system is the intelligent driving scenario.

For example, if it is determined based on the application information of the foreground application that the foreground application in the cockpit operating system includes the map application, it may be determined that the task scenario corresponding to the cockpit operating system is the navigation scenario.

In an implementation, the task scenario corresponding to the intelligent driving operating system and/or the cockpit operating system may be determined based on a vehicle status. For example, if the vehicle is in the driving status, such as operating at a D gear, it may be determined that the task scenario corresponding to the intelligent driving operating system and/or the cockpit operating system is the driving scenario. If the vehicle is in the parking status, such as operating at a P gear, it may be determined that the task scenario corresponding to the intelligent driving operating system and/or the cockpit operating system is the parking scenario.

In an implementation, the task scenario corresponding to the operating system may be determined based on a system status of the operating system. For example, if the operating system is in the standby status, it may be determined that the task scenario corresponding to the operating system is the standby scenario.

In an implementation, the task scenario corresponding to the operating system may be determined based on an input status of the operating system. For example, if the operating system is in a touch input status, for example, is responding to a touch operation of the user, it may be determined that the task scenario corresponding to the operating system is the touch scenario. If the operating system is in a voice input status, for example, is recognizing user voice, it may be determined that the task scenario corresponding to the operating system is the voice scenario.

Manners for determining the task scenario corresponding to the operating system are exemplarily described above. It may be understood that the foregoing examples are some but not all of the manners for determining the task scenario corresponding to the operating system. In practical applications, other manners may also be used to determine the task scenario corresponding to the operating system, which do not go beyond the protection scope of this embodiment of this disclosure.

Step 3312. Determine, based on the task scenario corresponding to the operating system running on the at least one target processor, the corresponding priority for the at least one target processor.

For any target processor, the operating system running thereon executes different tasks in different task scenarios, and the priority corresponding to the target processor also varies.

Taking that the target processor includes the processor A and the processor B, wherein the processor A runs the intelligent driving operating system, and the processor B runs the cockpit operating system as an example:
If the task scenario corresponding to the processor A is the intelligent driving scenario, and the task scenario corresponding to the processor B is the entertainment scenario, to ensure driving safety of the vehicle, the priority of the processor A is higher than that of the processor B. For example, the priority of the processor A is the high priority, and the priority of the processor B is the medium priority.

If the task scenario corresponding to the processor A is the standby scenario, and the task scenario corresponding to the processor B is the entertainment scenario, to ensure user experience when the cockpit operating system run on the processor B plays music, plays a video, and runs a game application, the priority of the processor B is higher than that of the processor A. For example, the priority of the processor A is the low priority, and the priority of the processor B is the medium priority.

In an implementation, each task scenario of the operating system has a corresponding relationship with the priority corresponding to the processor running the operating system. The corresponding priority of each target processor is determined by using the corresponding relationship based on the task scenario corresponding to the operating system run on each target processor.

For example, for the intelligent driving operating system, the intelligent driving scenario corresponds to the high priority, the manned driving scenario corresponds to the medium priority, the parking scenario corresponds to the low priority, and the standby scenario corresponds to the low priority. For the cockpit operating system, the intelligent driving scenario corresponds to the low priority, the manned driving scenario corresponds to the low priority, the parking scenario corresponds to the high priority, the entertainment scenario corresponds to the medium priority, and the navigation scenario corresponds to the high priority.

The corresponding relationships between various task scenarios and various priorities shown above are only examples, and may be flexibly configured based on actual requirements. This is not limited in this embodiment of this disclosure.

In an implementation, each task scenario of the operating system has a corresponding relationship with the priority value corresponding to the processor running the operating system. The corresponding priority value of each target processor is determined by using the corresponding relationship based on the task scenario corresponding to the operating system run on the target processor.

For example, for the intelligent driving operating system, the priority value corresponding to the intelligent driving scenario is 9, the priority value corresponding to the manned driving scenario is 6, the priority value corresponding to the parking scenario is 1, and the priority value corresponding to the standby scenario is 1. For the cockpit operating system, the priority value corresponding to the intelligent driving scenario is 1, the priority value corresponding to the manned driving scenario is 1, the priority value corresponding to the parking scenario is 8, the priority value corresponding to the entertainment scenario is 6, and the priority value corresponding to the navigation scenario is 7.

The corresponding relationships between various task scenarios and various priority values shown above are only examples, and may be flexibly configured based on actual requirements. This is not limited in this embodiment of this disclosure.

In this embodiment of this disclosure, the task scenario corresponding to the operating system run on the target processor is determined based on the foreground application in the operating system run on the target processor. Subsequently, the priority corresponding to the target processor is determined based on the task scenario corresponding to the operating system run on the target processor, so that the priority corresponding to the target processor is associated with the foreground application in the operating system. On this basis, a target application parameter of the target processor is determined based on the priority corresponding to the target processor, and the operating system on the target processor is run based on the target application parameter. In this way, the performance of the target processor can be enabled to match the performance requirements of the operating system when running the foreground application, thereby improving the stability of the target processor when running the operating system.

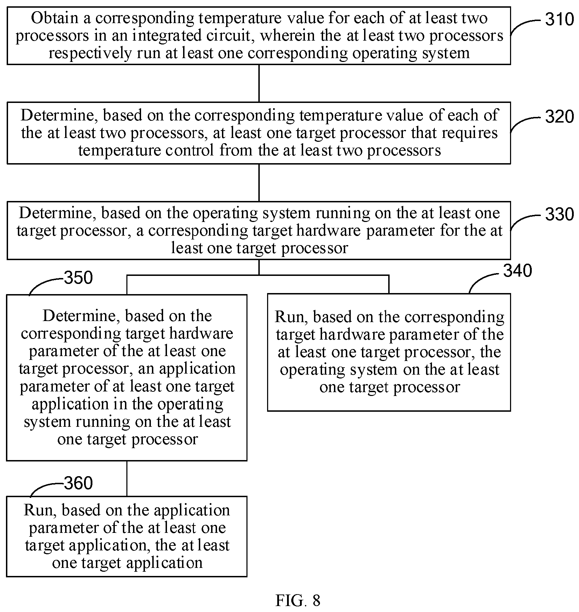

FIG. 8 is a flowchart of a method for implementing temperature control by adjusting a hardware parameter of a processor in an integrated circuit according to another exemplary embodiment of this disclosure.

As shown in FIG. 8, on the basis of the embodiment shown in FIG. 3, after step 330, the method may further include the following steps.

Step 350. Determine, based on the corresponding target hardware parameter of the at least one target processor, an application parameter of at least one target application in the operating system running on the at least one target processor.

For the operating system running on any target processor, the at least one target application may include applications running in the operating system, such as a running foreground application and a running background application.

For example, the cockpit operating system is used as an example. In the video scenario, the foreground application of the cockpit operating system includes a video application. Therefore, the target application includes the video application. In the game scenario, the foreground application of the cockpit operating system includes a game application. Therefore, the target application includes the game application. In the music scenario, the target application is a music application, which may be either a foreground application or a background application.

It may be understood that the target application in the operating system may include at least one application parameter, and for each target application, the operating system may run the target application based on any application parameter.

For example, the video application of the cockpit operating system is used as an example. Application parameters, in an ascending order, of the video application that are used for video playing may include:
an application parameter 1: video bitrate ≤ 600 kbps, video resolution ≤ 894 × 504, and video frame rate ≤ 25 fps;
an application parameter 2: video bitrate ≤ 1300 kbps, video resolution bitrate of video ≤ 1280 × 720, and video frame rate ≤ 30 fps; and
an application parameter 3: video bitrate ≤ 2300 kbps, video resolution ≤ 1920 × 1080, and video frame rate ≤ 30 fps;

It may be understood that for any target processor, the operating system run on the target processor has different performance requirements for the target processor when running the target application with different application parameters. A higher application parameter of the target application indicates higher performance requirements of the operating system for the target processor, and a lower application parameter of the target application indicates lower performance requirements of the operating system for the target processor. When the performance of the target processor is higher than the performance requirements of the operating system for the target processor, the operating system may run the target application stably. For example, when running the target application, the operating system would not experience frame freezing, frame drops, and other situations. When the performance of the target processor is lower than the performance requirements of the operating system for the target processor, the operating system cannot run the target application stably. For example, when running the target application, the operating system may experience frame freezing, frame drops, and other situations. In other words, to make sure that the operating system can run the target application stably, the performance of the target processor needs to match the performance requirements of the operating system for the target processor.

In addition, during the process of running the operating system on each target processor based on the corresponding target hardware parameter of each target processor, the performance of each target processor is related to the corresponding target hardware parameter thereof. Therefore, for each target processor, the application parameter of the at least one target application in the operating system run on the target processor may be determined based on the target hardware parameter of the target processor, so that the performance of the target processor matches the performance requirements of the operating system run on the target processor.

In an implementation, a corresponding relationship between the target hardware parameter of each target processor and the application parameter of the target application may be configured. The application parameter of the target application may be determined by using this corresponding relationship based on the target hardware parameter of the target processor.

For example, the target processor includes the processor A, which is a CPU and runs the cockpit operating system, and the target application includes the video application. When the target clock frequency of the processor A is 1.2 GHz, the application parameter for the video application is the application parameter 1. When the target clock frequency of the processor A is 1.6 GHz, the application parameter for the video application is the application parameter 2. When the target clock frequency of the processor A is 2.0 GHz, the application parameter for the video application is the application parameter 3.

Step 360. Run, based on the application parameter of the at least one target application, the at least one target application.

In specific implementation, for any target processor, during the process in which the target processor runs the operating system based on the corresponding target hardware parameter, the operating system may run the at least one target application based on the application parameter of the at least one target application.

For example, the target processor includes the processor A, which is a CPU and runs the cockpit operating system, and the target application includes the video application. When the target clock frequency of the processor A is 1.2 GHz, the cockpit operating system may run the video application based on the application parameter 1. When the target clock frequency of the processor A is 1.6 GHz, the cockpit operating system may run the video application based on the application parameter 2. When the target clock frequency of the processor A is 2.0 GHz, the cockpit operating system may run the video application based on the application parameter 3.

In this embodiment of this disclosure, the application parameter of the at least one target application in the operating system run on the target processor is determined based on the target hardware parameter corresponding to the target processor, so that the performance of the target processor matches the performance requirements of the operating system run on the target processor. Therefore, the operating system run on the target processor may run the at least one target application stably based on the application parameter of the at least one target application, without frame freezing or frame drops, thereby improving the user experience.

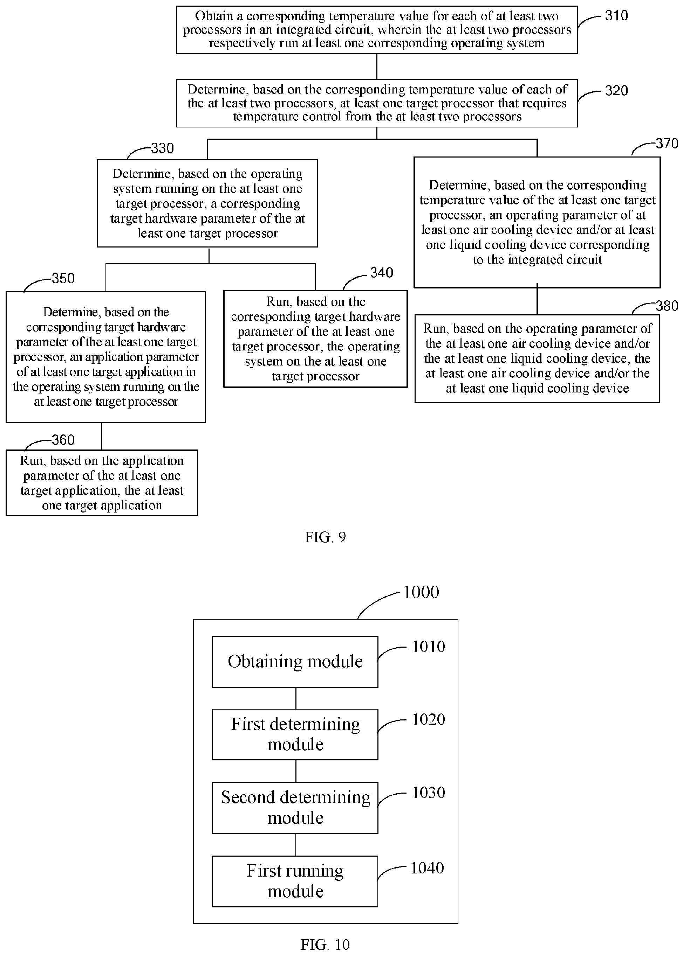

FIG. 9 is a flowchart of a method for implementing temperature control by adjusting a hardware parameter of a processor in an integrated circuit according to still another exemplary embodiment of this disclosure.

As shown in FIG. 9, on the basis of the embodiment shown in FIG. 3, after step 320, the method may further include the following steps.

Step 370. Determine, based on the corresponding temperature value of the at least one target processor, an operating parameter of at least one air cooling device and/or at least one liquid cooling device corresponding to the integrated circuit.

The air cooling device may include, for example, a radiator fan. The operating parameter of the air cooling device may include a rotational speed of the radiator fan. The liquid cooling device may include, for example, a liquid-cooling heat dissipation module. The operating parameter of the liquid cooling device may include a liquid flow rate of the liquid-cooling heat dissipation module.

In specific implementation, the operating parameter of the at least one air cooling device and/or the at least one liquid cooling device corresponding to the integrated circuit may be determined based on temperature values corresponding to some or all target processors in the at least one target processor.

In an example, the operating parameter of the at least one air cooling device and/or the at least one liquid cooling device corresponding to the integrated circuit may be determined based on a maximum temperature value among the corresponding temperature values of the at least one target processor. A larger maximum temperature value indicates a higher operating parameter of the at least one air cooling device and/or the at least one liquid cooling device; and a smaller maximum temperature value indicates a lower operating parameter of the at least one air cooling device and/or the at least one liquid cooling device. For example, a larger maximum temperature value indicates a higher rotational speed of the cooling fan and a higher liquid flow rate of the liquid-cooling heat dissipation module; and a smaller maximum temperature value indicates a lower rotational speed of the cooling fan and a lower liquid flow rate of the liquid-cooling heat dissipation module.

In an example, the operating parameter of the at least one air cooling device and/or the at least one liquid cooling device corresponding to the integrated circuit may be determined based on a minimum temperature value among the corresponding temperature values of the at least one target processor. A larger minimum temperature value indicates a higher operating parameter of the at least one air cooling device and/or the at least one liquid cooling device; and a smaller minimum temperature value indicates a lower operating parameter of the at least one air cooling device and/or the at least one liquid cooling device.

Step 380. Run, based on the operating parameter of the at least one air cooling device and/or the at least one liquid cooling device, the at least one air cooling device and/or the at least one liquid cooling device.

After the operating parameter of the at least one air cooling device and/or the at least one liquid cooling device is determined, the at least one air cooling device and/or the at least one liquid cooling device may be run based on the operating parameter of the at least one air cooling device and/or the at least one liquid cooling device. In this way, a larger corresponding temperature value of the at least one target processor indicates a higher operating parameter of the at least one air cooling device and/or the at least one liquid cooling device and a stronger heat dissipation capability, thus further facilitating temperature reduction of the at least one target processor.

In this embodiment of this disclosure, the operating parameter of the air cooling device and/or the liquid cooling device corresponding to the integrated circuit is determined based on the temperature value corresponding to the target processor, so that the operating parameter of the air cooling device and/or the liquid cooling device matches the temperature value corresponding to the target processor. In this way, running the air cooling device and/or the liquid cooling device based on the operating parameter of the air cooling device and/or the liquid cooling device may achieve the objective of adjusting the temperature of each processor in the integrated circuit, thereby improving the stability of each processor in the integrated circuit when running the operating system.

### Exemplary apparatus

FIG. 10 is a schematic diagram of a structure of an apparatus for implementing temperature control by adjusting a hardware parameter of a processor in an integrated circuit according to an exemplary embodiment of this disclosure. As shown in FIG. 10, an apparatus 1000 for implementing temperature control by adjusting a hardware parameter of a processor in an integrated circuit includes: an obtaining module 1010, configured to obtain a corresponding temperature value for each of at least two processors in the integrated circuit, wherein the at least two processors respectively run at least one corresponding operating system; a first determining module 1020, configured to determine, based on the corresponding temperature value of each of the at least two processors, at least one target processor that requires temperature control from the at least two processors; a second determining module 1030, configured to determine, based on the operating system running on the at least one target processor, a corresponding target hardware parameter for the at least one target processor; and a first running module 1040, configured to run, based on the corresponding target hardware parameter of the at least one target processor, the operating system on the at least one target processor.

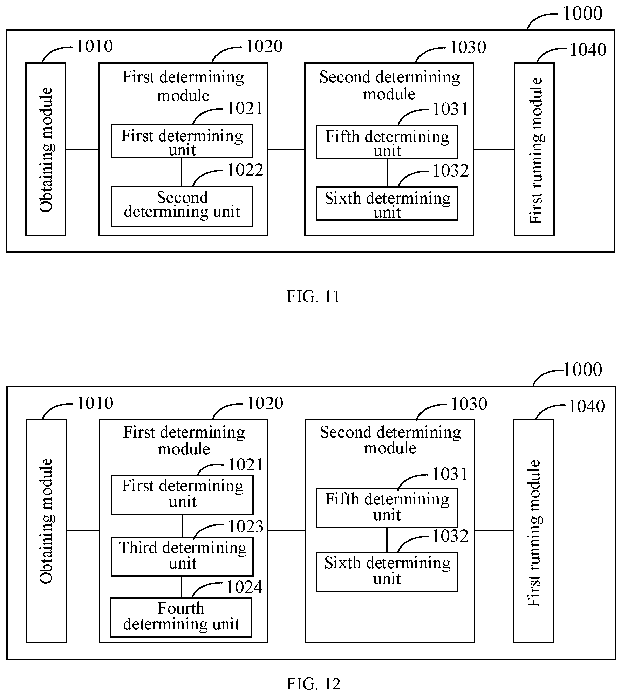

In an embodiment, as shown in FIG. 11, the first determining module 1020 includes: a first determining unit 1021, configured to determine, based on the corresponding temperature value of each of the at least two processors, at least one first processor with a temperature value greater than a temperature threshold from the at least two processors; and a second determining unit 1022, configured to determine, based on the at least one first processor, the at least one target processor.

In an embodiment, as shown in FIG. 12, the first determining module 1020 includes: a first determining unit 1021, configured to determine, based on the corresponding temperature value of each of the at least two processors, at least one first processor with a temperature value greater than a temperature threshold from the at least two processors; a third determining unit 1023, configured to determine, based on the at least one first processor, at least one second processor from the at least two processors on which an operating system different from the one running on the at least one first processor runs; and a fourth determining unit 1024, configured to determine, based on the at least one first processor and the at least one second processor, the at least one target processor.

In an embodiment, as shown in FIG. 11 or FIG, 12, the second determining module 1030 includes: a fifth determining unit 1031, configured to determine, based on the operating system running on the at least one target processor, a corresponding priority for the at least one target processor; and a sixth determining unit 1032, configured to determine, based on the corresponding priority of the at least one target processor, the corresponding target hardware parameter for the at least one target processor.

In an embodiment, the fifth determining unit 1031 includes: a first determining subunit, configured to determine, based on a foreground application in the operating system running on the at least one target processor, a task scenario corresponding to the operating systems respectively running on the at least one target processor; and a second determining subunit, configured to determine, based on the task scenario corresponding to the operating systems respectively running on the at least one target processor, the corresponding priority for the at least one target processor.

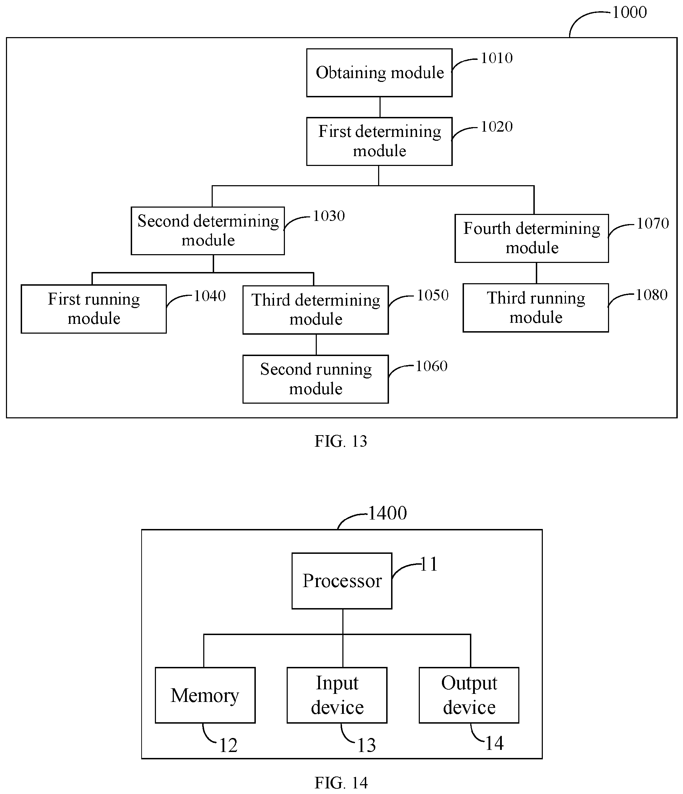

In an embodiment, as shown in FIG. 13, the apparatus for implementing temperature control by adjusting a hardware parameter of a processor in an integrated circuit further includes: a third determining module 1050, configured to determine, based on the corresponding target hardware parameter of the at least one target processor, an application parameter of at least one target application in the operating system running on the at least one target processor; and a second running module 1060, configured to run, based on the application parameter of the at least one target application, the at least one target application.

In an embodiment, as shown in FIG. 13, the apparatus for implementing temperature control by adjusting a hardware parameter of a processor in an integrated circuit further includes: a fourth determining module 1070, configured to determine, based on the corresponding temperature value of the at least one target processor, an operating parameter of at least one air cooling device and/or at least one liquid cooling device corresponding to the integrated circuit; and a third running module 1080, configured to run, based on the operating parameter of the at least one air cooling device and/or the at least one liquid cooling device, the at least one air cooling device and/or the at least one liquid cooling device.

For beneficial technical effects corresponding to the exemplary embodiments of this apparatus, reference may be made to the corresponding beneficial technical effects in the section of exemplary method described above, and details are not described herein again.

### Exemplary electronic device

FIG. 14 is a diagram of a structure of an electronic device according to an exemplary embodiment of this disclosure. An electronic device 1400 includes at least one processor 11 and a memory 12.

The processor 11 may be a central processing unit (CPU) or another form of processing unit having a data processing capability and/or an instruction execution capability, and may control other components in the electronic device 1400 to implement desired functions.

The memory 12 may include one or more computer program products, which may include various forms of computer readable storage media, such as a volatile memory and/or a non-volatile memory. The volatile memory may include, for example, a random access memory (RAM) and/or a cache. The nonvolatile memory may include, for example, a read-only memory (ROM), a hard disk, and a flash memory. One or more computer program instructions may be stored on the computer readable storage medium. The processor 11 may execute the one or more program instructions to implement the method for implementing temperature control by adjusting a hardware parameter of a processor in an integrated circuit according to the various embodiments of this disclosure that are described above and/or other desired functions.

In an example, the electronic device 1400 may further include an input device 13 and an output device 14. These components are connected to each other through a bus system and/or another form of connection mechanism (not shown).

The input device 13 may also include sensors such as a camera, a laser radar, a millimeter wave radar, an ultrasonic radar, a seat sensor, a microphone, a steering wheel, an accelerator pedal, and a brake pedal.

The output device 14 may output various information to the outside, and may include, for example, a display, a speaker, a communication network, and a remote output device connected to the communication network.

Certainly, for simplicity, FIG. 14 shows only some of components in the electronic device 1400 that are related to this disclosure, and components such as a bus and an input/output interface are omitted. In addition, according to specific application situations, the electronic device 1400 may further include any other appropriate components.

### Exemplary computer program product and computer readable storage medium

In addition to the foregoing method and device, embodiments of this disclosure may also relate to a computer program product, which includes computer program instructions. When the computer program instructions are run by a processor, the processor is enabled to perform the steps, of the method for implementing temperature control by adjusting a hardware parameter of a processor in an integrated circuit according to the embodiments of this disclosure, that are described in the "Exemplary method" section of this specification.

The computer program product may be program code, written with one or any combination of a plurality of programming languages, which is configured to perform the operations in the embodiments of this disclosure. The programming languages include an object-oriented programming language such as Java or C++, and further include a conventional procedural programming language such as a "C" language or a similar programming language. The program code may be entirely or partially executed on a user computing device, executed as an independent software package, partially executed on the user computing device and partially executed on a remote computing device, or entirely executed on the remote computing device or a server.

In addition, the embodiments of this disclosure may further relate to a computer readable storage medium, which stores computer program instructions. When the computer program instructions are run by the processor, the processor is enabled to perform the steps, of the method for implementing temperature control by adjusting a hardware parameter of a processor in an integrated circuit according to the embodiments of this disclosure, that are described in the "Exemplary method" section of this specification.

The computer readable storage medium may be one readable medium or any combination of a plurality of readable media. The readable medium may be a readable signal medium or a readable storage medium. The readable storage medium may include, for example but is not limited to electricity, magnetism, light, electromagnetism, infrared ray, or a semiconductor system, an apparatus, or a device, or any combination of the above. More specific examples (a non-exhaustive list) of the readable storage medium include: an electrical connection with one or more conducting wires, a portable disk, a hard disk, a random access memory (RAM), a read-only memory (ROM), an erasable programmable read-only memory (EPROM or a flash memory), an optical fiber, a portable compact disk read-only memory (CD-ROM), an optical storage device, a magnetic storage device, or any suitable combination of the above.

Basic principles of this disclosure are described above in combination with specific embodiments. However, it should be pointed out that the advantages, superiorities, and effects mentioned in this disclosure are merely examples but are not for limitation, and it cannot be considered that these advantages, superiorities, and effects are necessary for each embodiment of this disclosure. In addition, specific details described above are merely for examples and for ease of understanding, rather than limitations. The details described above do not limit that this disclosure must be implemented by using the foregoing specific details.

A person skilled in the art may make various modifications and variations to this disclosure without departing from the spirit and the scope of this application. In this way, if these modifications and variations of this application fall within the scope of the claims and equivalent technologies of the claims of this disclosure, this disclosure also intends to include these modifications and variations.

## Claims

1. A method for implementing temperature control by adjusting a hardware parameter of a processor in an integrated circuit, **characterized in that** the method for implementing temperature control by adjusting a hardware parameter of a processor in an integrated circuit comprises:
obtaining (310) a corresponding temperature value for each of at least two processors in the integrated circuit, wherein the at least two processors respectively run at least one corresponding operating system;
determining (320), based on the corresponding temperature value of each of the at least two processors, at least one target processor that requires temperature control from the at least two processors;
determining (330), based on the operating systems respectively running on the at least one target processor, a corresponding target hardware parameter for the at least one target processor; and
running (340), based on the corresponding target hardware parameter of the at least one target processor, the operating system on the at least one target processor.

2. The method according to claim 1, wherein the determining (320), based on the corresponding temperature value of each of the at least two processors, at least one target processor that requires temperature control from the at least two processors comprises:
determining (321), based on the corresponding temperature value of each of the at least two processors, at least one first processor with a temperature value greater than a temperature threshold from the at least two processors; and
determining (322), based on the at least one first processor, the at least one target processor.

3. The method according to claim 1, wherein the determining (320), based on the corresponding temperature value of each of the at least two processors, at least one target processor that requires temperature control from the at least two processors comprises:
determining (323), based on the corresponding temperature value of each of the at least two processors, at least one first processor with a temperature value greater than a temperature threshold from the at least two processors;
determining (324), based on the at least one first processor, at least one second processor from the at least two processors on which an operating system different from the one running on the at least one first processor runs; and
determining (325), based on the at least one first processor and the at least one second processor, the at least one target processor.

4. The method according to any one of claims 1 to 3, wherein the determining (330), based on the operating system running on the at least one target processor, a corresponding target hardware parameter for the at least one target processor comprises:
determining (331), based on the operating system running on the at least one target processor, a corresponding priority for the at least one target processor; and
determining (332), based on the corresponding priority of each of the at least one target processor, the corresponding target hardware parameter for the at least one target processor.

5. The method according to claim 4, wherein the determining (331), based on the operating systems respectively running on the at least one target processor, a corresponding priority for each of the at least one target processor comprises:
determining (3311), based on a foreground application in the operating system running on the at least one target processor, a task scenario corresponding to the operating system running on the at least one target processor; and
determining (3312), based on the task scenario corresponding to the operating systems respectively running on the at least one target processor, the corresponding priority for the at least one target processor.

6. The method according to any one of claims 1 to 3, wherein after the determining (330), based on the operating system running on the at least one target processor, a corresponding target hardware parameter for the at least one target processor, the method further comprises:
determining (350), based on the corresponding target hardware parameter of the at least one target processor, an application parameter of at least one target application in the operating system running on the at least one target processor; and
running (360), based on the application parameter of the at least one target application, the at least one target application.

7. The method according to any one of claims 1 to 3, wherein after the determining (320), based on the corresponding temperature value of each of the at least two processors, at least one target processor that requires temperature control from the at least two processors, the method further comprises:
determining (370), based on the corresponding temperature value of the at least one target processor, an operating parameter of at least one air cooling device and/or at least one liquid cooling device corresponding to the integrated circuit; and
running (380), based on the operating parameter of the at least one air cooling device and/or the at least one liquid cooling device, the at least one air cooling device and/or the at least one liquid cooling device.

8. An apparatus for implementing temperature control by adjusting a hardware parameter of a processor in an integrated circuit, **characterized in that** the apparatus comprises:
an obtaining module (1010), configured to obtain a corresponding temperature value for each of at least two processors in the integrated circuit, wherein the at least two processors respectively run at least one corresponding operating system;
a first determining module (1020), configured to determine, based on the corresponding temperature value of each of the at least two processors, at least one target processor that requires temperature control from the at least two processors;
a second determining module (1030), configured to determine, based on the operating systems respectively running on the at least one target processor, a corresponding target hardware parameter for the at least one target processor; and
a first running module (1040), configured to run, based on the corresponding target hardware parameter of the at least one target processor, the operating system on the at least one target processor.

9. The apparatus according to claim 8, wherein the first determining module (1020) comprises:
a first determining unit (1021), configured to determine, based on the corresponding temperature value of each of the at least two processors, at least one first processor with a temperature value greater than a temperature threshold from the at least two processors; and
a second determining unit (1022), configured to determine, based on the at least one first processor, the at least one target processor.

10. The apparatus according to claim 8, wherein the first determining module (1020) further comprises:
a third determining unit (1023), configured to determine, based on the at least one first processor, at least one second processor from the at least two processors on which an operating system different from the one running on the at least one first processor runs; and
a fourth determining unit (1024), configured to determine, based on the at least one first processor and the at least one second processor, the at least one target processor.

11. The apparatus according to claim 8, wherein the second determining module (1030) comprises:
a fifth determining unit (1031), configured to determine, based on the operating system running on the at least one target processor, a corresponding priority for the at least one target processor; and
a sixth determining unit (1032), configured to determine, based on the corresponding priority of the at least one target processor, the corresponding target hardware parameter for the at least one target processor.

12. The apparatus according to claim 11, wherein the fifth determining unit (1031) comprises:
a first determining subunit, configured to determine, based on a foreground application in the operating system running on the at least one target processor, a task scenario corresponding to the operating systems respectively running on the at least one target processor; and
a second determining subunit, configured to determine, based on the task scenario corresponding to the operating systems respectively running on the at least one target processor, the corresponding priority for the at least one target processor.

13. The apparatus according to claim 11, further comprises:
a third determining module (1050), configured to determine, based on the corresponding target hardware parameter of the at least one target processor, an application parameter of at least one target application in the operating system running on the at least one target processor; and
a second running module (1060), configured to run, based on the application parameter of the at least one target application, the at least one target application.

14. A computer readable storage medium, wherein the storage medium stores a computer program, and the computer program is used for implementing a method for implementing temperature control by adjusting a hardware parameter of a processor in an integrated circuit according to any one of claims 1 to 7.

15. An electronic device, **characterized in that** the electronic device comprises:
a processor (11); and
a memory (12), configured to store processor-executable instructions, wherein
the processor (11) is configured to read the executable instructions from the memory (12), and execute the instructions to implement a method for implementing temperature control by adjusting a hardware parameter of a processor in an integrated circuit according to any one of claims 1 to 7.

## Amended claims

### Amended claims in accordance with Rule 137(2) EPC.

1. A method for implementing temperature control by adjusting a hardware parameter of a processor in an integrated circuit, **characterized in that** the method for implementing temperature control by adjusting a hardware parameter of a processor in an integrated circuit comprises:
obtaining (310) a corresponding temperature value for each of at least two processors in the integrated circuit, wherein the at least two processors respectively run at least one corresponding operating system;
determining (320), based on a relationship between the corresponding temperature value and a corresponding temperature threshold of each of the at least two processors, at least one target processor that requires temperature control from the at least two processors;
determining (330), based on the operating systems respectively running on the at least one target processor, a corresponding target hardware parameter for the at least one target processor; and
running (340), based on the corresponding target hardware parameter of the at least one target processor, the operating system on the at least one target processor.

2. The method according to claim 1, wherein the determining (320), based on a relationship between the corresponding temperature value and a corresponding temperature threshold of each of the at least two processors, at least one target processor that requires temperature control from the at least two processors comprises:
determining (321), based on the corresponding temperature value of each of the at least two processors, at least one first processor with a temperature value greater than the corresponding temperature threshold of each of the at least two processors from the at least two processors; and
determining (322), based on the at least one first processor, the at least one target processor.

3. The method according to claim 1, wherein the determining (320), based on a relationship between the corresponding temperature value and a corresponding temperature threshold of each of the at least two processors, at least one target processor that requires temperature control from the at least two processors comprises:
determining (323), based on the corresponding temperature value of each of the at least two processors, at least one first processor with a temperature value greater than the corresponding temperature threshold of each of the at least two processors from the at least two processors;
determining (324), based on the at least one first processor, at least one second processor from the at least two processors on which an operating system different from the one running on the at least one first processor runs; and
determining (325), based on the at least one first processor and the at least one second processor, the at least one target processor.

4. The method according to any one of claims 1 to 3, wherein the determining (330), based on the operating system running on the at least one target processor, a corresponding target hardware parameter for the at least one target processor comprises:
determining (331), based on the operating system running on the at least one target processor, a corresponding priority for the at least one target processor; and
determining (332), based on the corresponding priority of each of the at least one target processor, the corresponding target hardware parameter for the at least one target processor.

5. The method according to claim 4, wherein the determining (331), based on the operating systems respectively running on the at least one target processor, a corresponding priority for each of the at least one target processor comprises:
determining (3311), based on a foreground application in the operating system running on the at least one target processor, a task scenario corresponding to the operating system running on the at least one target processor; and
determining (3312), based on the task scenario corresponding to the operating systems respectively running on the at least one target processor, the corresponding priority for the at least one target processor.

6. The method according to any one of claims 1 to 3, wherein after the determining (330), based on the operating system running on the at least one target processor, a corresponding target hardware parameter for the at least one target processor, the method further comprises:
determining (350), based on the corresponding target hardware parameter of the at least one target processor, an application parameter of at least one target application in the operating system running on the at least one target processor; and
running (360), based on the application parameter of the at least one target application, the at least one target application.

7. The method according to any one of claims 1 to 3, wherein after the determining (320), based on a relationship between the corresponding temperature value and a corresponding temperature threshold of each of the at least two processors, at least one target processor that requires temperature control from the at least two processors, the method further comprises:
determining (370), based on the corresponding temperature value of the at least one target processor, an operating parameter of at least one air cooling device and/or at least one liquid cooling device corresponding to the integrated circuit; and
running (380), based on the operating parameter of the at least one air cooling device and/or the at least one liquid cooling device, the at least one air cooling device and/or the at least one liquid cooling device.

8. An apparatus for implementing temperature control by adjusting a hardware parameter of a processor in an integrated circuit, **characterized in that** the apparatus comprises:
an obtaining module (1010), configured to obtain a corresponding temperature value for each of at least two processors in the integrated circuit, wherein the at least two processors respectively run at least one corresponding operating system;
a first determining module (1020), configured to determine, based on a relationship between the corresponding temperature value and a corresponding temperature threshold of each of the at least two processors, at least one target processor that requires temperature control from the at least two processors;
a second determining module (1030), configured to determine, based on the operating systems respectively running on the at least one target processor, a corresponding target hardware parameter for the at least one target processor; and
a first running module (1040), configured to run, based on the corresponding target hardware parameter of the at least one target processor, the operating system on the at least one target processor.

9. The apparatus according to claim 8, wherein the first determining module (1020) comprises:
a first determining unit (1021), configured to determine, based on the corresponding temperature value of each of the at least two processors, at least one first processor with a temperature value greater than the corresponding temperature threshold of each of the at least two processors from the at least two processors; and
a second determining unit (1022), configured to determine, based on the at least one first processor, the at least one target processor.

10. The apparatus according to claim 8, wherein the first determining module (1020) further comprises:
a first determining unit (1021), configured to determine, based on the corresponding temperature value of each of the at least two processors, at least one first processor with a temperature value greater than the corresponding temperature threshold of each of the at least two processors from the at least two processors;
a third determining unit (1023), configured to determine, based on the at least one first processor, at least one second processor from the at least two processors on which an operating system different from the one running on the at least one first processor runs; and
a fourth determining unit (1024), configured to determine, based on the at least one first processor and the at least one second processor, the at least one target processor.

11. The apparatus according to claim 8, wherein the second determining module (1030) comprises:
a fifth determining unit (1031), configured to determine, based on the operating system running on the at least one target processor, a corresponding priority for the at least one target processor; and
a sixth determining unit (1032), configured to determine, based on the corresponding priority of the at least one target processor, the corresponding target hardware parameter for the at least one target processor.

12. The apparatus according to claim 11, wherein the fifth determining unit (1031) comprises:
a first determining subunit, configured to determine, based on a foreground application in the operating system running on the at least one target processor, a task scenario corresponding to the operating systems respectively running on the at least one target processor; and
a second determining subunit, configured to determine, based on the task scenario corresponding to the operating systems respectively running on the at least one target processor, the corresponding priority for the at least one target processor.

13. The apparatus according to claim 11, further comprises:
a third determining module (1050), configured to determine, based on the corresponding target hardware parameter of the at least one target processor, an application parameter of at least one target application in the operating system running on the at least one target processor; and
a second running module (1060), configured to run, based on the application parameter of the at least one target application, the at least one target application.

14. A computer readable storage medium, wherein the storage medium stores a computer program, and the computer program is used for implementing a method for implementing temperature control by adjusting a hardware parameter of a processor in an integrated circuit according to any one of claims 1 to 7.

15. An electronic device, **characterized in that** the electronic device comprises:
a processor (11); and
a memory (12), configured to store processor-executable instructions, wherein
the processor (11) is configured to read the executable instructions from the memory (12), and execute the instructions to implement a method for implementing temperature control by adjusting a hardware parameter of a processor in an integrated circuit according to any one of claims 1 to 7.
